# EUROPEAN PATENT SPECIFICATION

(11) **EP 4 467 456 B1**
(45) Date of publication and mention of the grant of the patent: **04.11.2026**
(21) Application number: 24176981.9
(22) Date of filing: 21.05.2024
(51) Int. Cl.: G01P 5/165, B64D 15/20, G01N 29/24, H10N 35/80, B33Y 80/00, G01N 29/12, H10N 35/00

(54) **ADDITIVE MANUFACTURED PERMANENT MAGNETS IN MAGNETO STRICTIVE OSCILLATING ICE DETECTOR SENSORS**
ADDITIV GEFERTIGTE PERMANENTMAGNETE IN MAGNETOSTRIKTIVEN OSZILLIERENDEN EISDETEKTORSENSOREN
AIMANTS PERMANENTS FABRIQUÉS DE MANIÈRE ADDITIVE DANS DES CAPTEURS DE DÉTECTEUR DE GLACE À OSCILLATION MAGNÉTO-STRICTIVE

(30) Priority: 22.05.2023 US 202318200213
(43) Date of publication of application: 27.11.2024
(73) Proprietor: ROSEMOUNT AEROSPACE INC., Burnsville, MN 55306-4898 (US)
(72) Inventor: ROMAN, Jamison K., Elko (US); WEBB, Matthew, Lakeville (US)
(74) Representative: Dehns

(56) References cited:
- EP-A1- 4 301 118
- KR-B1- 101 964 981
- US-A1- 2022 196 600
- US-A1- 2022 381 627

## Description

### TECHNICAL FIELD

The present disclosure relates to ice detection sensors, and more particularly to ice detection sensors with magneto strictive oscillating configurations.

### BACKGROUND

Traditional magneto strictive oscillator ice detector sensors utilize a permanent magnet (PMG) as part of the system operation to induce a static field bias. The strength and uniformity of the permanent magnet affect the oscillation of the sensing element. The sensing element oscillates position, driven by a drive coil. The system monitors the oscillations, and changes in the oscillation are indicative of changes in icing on the sensor.

The conventional techniques have been considered satisfactory for their intended purpose. However, there is an ever present need for improved systems and methods for magneto strictive oscillator ice detector sensors. This disclosure provides a solution for this need.

US 2022381627 A1 describes a freezing detection device comprising a strut having a mounting space formed therein, the strut being installed in a freezing measurement area in which a freezing detection object unit is disposed; a probe made of a magnetostrictive material and disposed to penetrate the strut, the lower end of the probe being inserted into the mounting space, the upper end thereof being exposed to the freezing measurement area.

### SUMMARY

According to an aspect, there is provided an ice detection sensor apparatus that includes a strut body extending along a longitudinal axis. The strut body includes an axially extending wall extending around the longitudinal axis to surround an interior space, and an axial-facing end wall connected to an axial end of the axially extending wall. The axial-facing end wall partially bounds the interior space. A magneto strictive oscillator sensing element extends from the interior space, through the axial-facing end wall. The sensing element is engaged to the axial-facing end wall for oscillation along the longitudinal axis relative to the axial-facing end wall. An oscillation driver within the interior space is operatively connected to the sensing element to drive oscillation of the sensing element. An oscillation detector within the interior space is operatively connected to detect oscillation of the sensing element for ice detection. A permanent magnet (PMG) element is integral with, e.g., monolithic with, the strut body. The strut is additively manufactured of a base material with an integrated permanent magnet (PMG) element, wherein the base material and PMG element are formed together layer by layer.

The PMG element can include a PMG that is ring shaped, is concentric with the sensing element, and extends along a majority of an axial length of the sensing element. It is also contemplated that the PMG element can include at least one of: a first permanent magnet (PMG) that is lateral from the sensing element relative to the longitudinal axis, and a second PMG that is concentric with the sensing element relative to the longitudinal axis. The first PMG can extend along a greater axial extent of the sensing element than does the second PMG. The first PMG can be cylindrical and can extend longitudinally parallel to the longitudinal axis. The second PMG can be in an annular cylinder shape axially aligned and concentric with the sensing element. The strut can be of aluminum. The first PMG and the second PMG can be of rare earth magnetic material.

A spring can be operatively connected to an end of the sensing element inside the interior space. The spring can be configured to bias the sensing element during oscillations of the sensing element. A base can be connected to the strut and can enclose the interior space in cooperation with the axially extending wall and with the axially-facing end wall. The base can house a controller operatively connected to the oscillation driver and to the oscillation detector for detecting ice formation on the sensing element and outputting data indicative of icing state of the sensing element.

According to an aspect, there is provided a method of making an ice detection sensor apparatus that includes additively manufacturing a strut of a base material with an integrated permanent magnet (PMG) element. The base material and PMG element are formed together layer by layer. The method includes assembling a magneto strictive oscillator sensing element, an oscillation driver operatively connected to the sensing element to drive oscillation of the sensing element, and an oscillation detector operatively connected to detect oscillation of the sensing element for ice detection in an interior space of the strut with a portion of the sensing element extending through the strut to a space exterior of the strut.

In forming the base material and PMG element layer by layer, at least some layers can include both PMG material and the base material together in the same layer. The base material can be a non-ferromagnetic metal. The base material can be aluminum.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic perspective view of an embodiment of an ice detection sensor apparatus constructed in accordance with the present disclosure, showing the base, the strut, and the sensing element extending from the strut;
Fig. 2 is a cross-sectional side elevation schematic view of a portion of the apparatus of Fig. 1, showing the permanent magnets (PMGs) integral with the strut;
Fig. 3 is a schematic perspective view of a portion of the apparatus of Fig. 1, showing magnetic fields for the PMGs relative to the sensing element;
Fig. 4 is a schematic perspective view of a portion of the apparatus of Fig. 1, showing a single PMG configuration with a long, radially uniform magnetic field;
Fig. 5 is an exploded schematic view of the strut of Fig. 2, showing layers of the strut that include both the base material and the PMG material in a given layer; and
Fig. 6 is a cross-sectional perspective view of the strut of Fig. 1 with the PMG of Fig. 4.

### DETAILED DESCRIPTION OF THE PREFERRED EMBODIMENTS

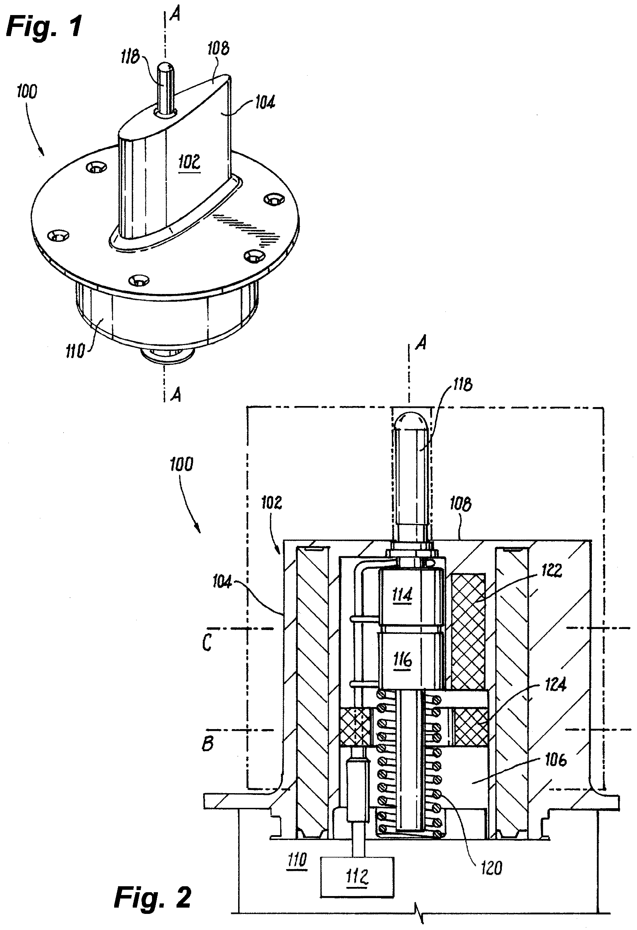

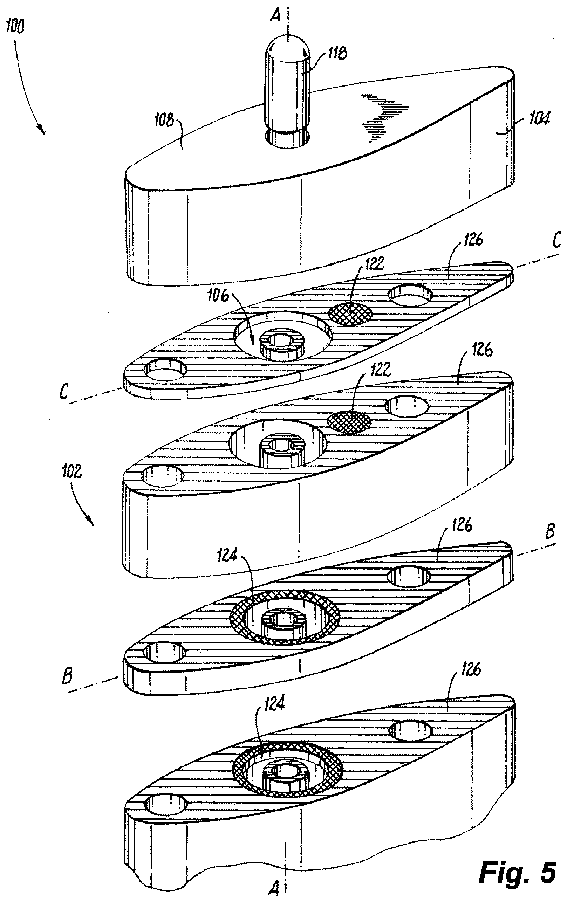

Reference will now be made to the drawings wherein like reference numerals identify similar structural features or aspects of the subject disclosure. For purposes of explanation and illustration, and not limitation, a partial view of an embodiment of an apparatus in accordance with the disclosure is shown in Fig. 1 and is designated generally by reference character 100. Other embodiments of systems in accordance with the disclosure, or aspects thereof, are provided in Figs. 2-5, as will be described. The systems and methods described herein can be used to provide improved permanent magnet (PMG) fields in magneto strictive ice detection sensors relative to traditional configurations.

An ice detection sensor apparatus 100 includes a strut body 102 extending along a longitudinal axis A. The strut body 102 includes an axially extending wall 104 extending around the longitudinal axis A to surround an interior space 106 (labeled in Fig. 2), and an axial-facing end wall 108 connected to an axial end of the axially extending wall 104. A base 110 is connected to the strut 102 and encloses the interior space 106 (labeled in Fig. 2) in cooperation with the axially extending wall 104 and with the axially-facing end wall 108.

With reference now to Fig. 2, a magneto strictive oscillator sensing element 118 extends from the interior space 106, through the axial-facing end wall 108. The sensing element 118 is engaged to the axial-facing end wall 108 for oscillation along the longitudinal axis A relative to the axial-facing end wall 108. A spring 120 is operatively connected to an end of the drive and feedback coils 114, 116 inside the interior space 106. The spring 120 is configured to restrain the location of drive and feedback coils 114, 116 during oscillations of the sensing element 118. An oscillation driver or drive coil 114, e.g. including an electromagnetic coil, piezoresistive actuators, or the like, is housed within the interior space 106 and is operatively connected to the sensing element 118 to drive oscillation of the sensing element 118. An oscillation detector or feedback coil 116 within the interior space is operatively connected to detect oscillation of the sensing element 118 for ice detection, i.e. the frequency of oscillation changes depending on how much ice is accreted on the exterior portion of the sending element 118. The base 110 houses a controller 112 operatively connected to the oscillation driver 114 and to the oscillation detector 116 for detecting ice formation exterior on the sensing element 118 and outputting data indicative of icing state of the sensing element 118, e.g. for use by pilots, autopilots, avionics, and the like.

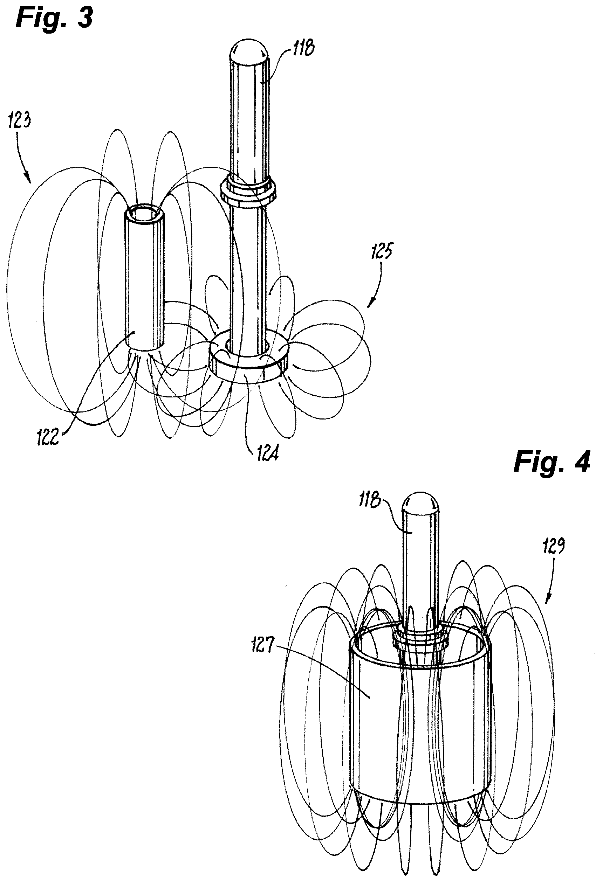

With continued reference to Fig. 2, a first permanent magnet (PMG) 122 is lateral from the sensing element 118 relative to the longitudinal axis A. A second PMG 124 is concentric with the sensing element 118 relative to the longitudinal axis A. While shown and described as being used together, those skilled in the art will readily appreciate that it is not necessary to include both PMGs 122 and 124. The axially extending wall 104, the axially-facing end wall 108, the first PMG 122, and the second PMG 124 are all monolithic with one another. The first PMG 122 extends along a greater axial extent of the sensing element 118 than does the second PMG 124, to provide a static biasing magnetic field 123, labeled in Fig. 3, with long coupling length to the sensing element 118. The first PMG 122 is cylindrical and extends longitudinally parallel to the longitudinal axis A. The second PMG 124 is in an annular cylinder shape, axially aligned and concentric with the sensing element for a component of radially uniform field 125, labeled in Fig. 3, in the static magnetic field for biasing the sensing element 118 relative to the axis A. The strut 104 can be made of a non-ferromagnetic material such as aluminum. The first and second PMGs 122, 124 are of rare earth magnetic material or of any other suitable magnetic material. As shown in Fig. 4, it is also contemplated that a single PMG 127 can be used that is ring shaped, concentric with the sensing element 118, and extends along a majority of the axial length of the sensing element 118, with a long, radially uniform magnetic field 129.

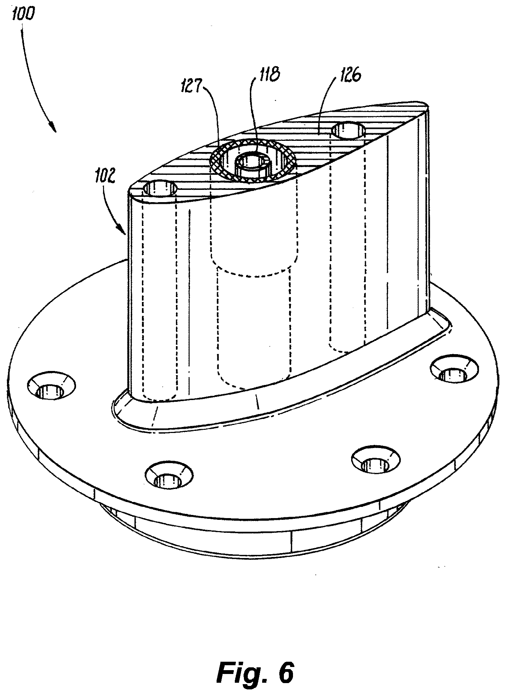

With reference now to Fig. 3, a method of making an ice detection sensor apparatus 100 includes additively manufacturing a strut 102 of a base material with an integrated first permanent magnet (PMG) 122 and an integrated second PMG 124. The base material, first PMG, and second PMG are formed together layer by layer, e.g. where two of the layers labeled B and C are shown individually separated from the other layers of the strut 102 in Fig. 3. In forming the base material 126, first PMG 122, and second PMG 124 layer by layer, at least some layers, e.g. layers B and C in Fig. 3, also identified in Fig. 2, include both PMG material and the base material 126 together, integral with one another in the same layer. The base material 126, the first PMG 122, and the second PMG 124 are all formed monolithic with one another at the completion of the additive manufacturing. With reference to Fig. 2, the method includes assembling the magneto strictive oscillator sensing element 118, the oscillation driver 114, and the oscillation detector 116 into the interior space 106 of the strut 102 with a portion of the sensing element 118 extending through the strut to a space exterior of the strut 102. Fig. 6 shows a cross section of the strut 102 for the case where the PMG 127 of Fig. 4 is used, where the PMG 127 and base material 126 are monolithic with one another in the same layer of the cross-section.

Systems and methods as disclosed herein provide potential benefits including the following. The strength and uniformity of the permanent magnets have an effect on the oscillation of the sensing element. Forming the permanent magnets using an additive manufacturing process adds more precise control of the coupling regions relative to the traditional configurations. Other potential benefits also include reduction of parts for the assembly, i.e. a cost reduction both in cost of goods and manual labor installation.

The methods and systems of the present disclosure, as described above and shown in the drawings, provide for improved PMG fields in magneto strictive ice detection sensors relative to traditional configurations. While the apparatus and methods of the subject disclosure have been shown and described with reference to preferred embodiments, those skilled in the art will readily appreciate that changes and/or modifications may be made thereto without departing from the scope of the subject disclosure. The invention is defined by the appended claims.

## Claims

1. An ice detection sensor apparatus (100) comprising:
a strut (102) extending along a longitudinal axis (A), the strut (102) including an axially extending wall (104) extending around the longitudinal axis (A) to surround an interior space (106), and an axial-facing end wall (108) connected to an axial end of the axially extending wall (104), wherein the axial-facing end wall (108) partially bounds the interior space (106);
a magneto strictive oscillator sensing element (118) extending from the interior space (106), through the axial-facing end wall (108), wherein the sensing element (118) is engaged to the axial-facing end wall (108) for oscillation along the longitudinal axis (A) relative to the axial-facing end wall (108);
an oscillation driver (114) within the interior space (106) operatively connected to the sensing element (118) to drive oscillation of the sensing element (118); and
an oscillation detector (116) within the interior space (106), operatively connected to detect oscillation of the sensing element (118) for ice detection;
**characterised by** a permanent magnet, PMG, element (122) monolithic with the strut (102),
wherein the strut (102) is additively manufactured of a base material (126) with the integrated permanent magnet element (122), wherein the base material (126) and the PMG element (122) are formed together layer by layer.

2. The apparatus as recited in claim 1, wherein the PMG element (122) includes a PMG that is ring shaped, is concentric with the sensing element (118), and extends along a majority of an axial length of the sensing element (118).

3. The apparatus as recited in claim 1 or 2, the PMG element (122) includes at least one of:
a first permanent magnet, PMG, lateral from the sensing element (118) relative to the longitudinal axis (A); and
a second PMG concentric with the sensing element (118) relative to the longitudinal axis (A).

4. The apparatus as recited in claim 3, wherein the PMG element (122) includes both the first and second PMGs, wherein the axially extending wall (104), the axially-facing end wall (108), the first PMG (122), and the second PMG (124) are all monolithic with one another.

5. The apparatus as recited in claim 3 or 4, wherein the first PMG (122) extends along a greater axial extent of the sensing element (118) than does the second PMG (124).

6. The apparatus as recited in claim 3, 4 or 5, wherein the PMG element (122) includes the first PMG (122), wherein the first PMG (122) is cylindrical and extends longitudinally parallel to the longitudinal axis (A).

7. The apparatus as recited in any of claims 3 to 6, wherein the PMG element (122) includes the second PMG (124), wherein the second PMG (124) is in an annular cylinder shape axially aligned and concentric with the sensing element (118).

8. The apparatus as recited in any preceding claim, further comprising a spring (120) operatively connected to an end of the sensing element (118) inside the interior space (106), wherein the spring (120) is configured to bias the sensing element (118) during oscillations of the sensing element (118).

9. The apparatus as recited in any preceding claim, further comprising a base (110) connected to the strut (102) and enclosing the interior space (106) in cooperation with the axially extending wall (104) and with the axially-facing end wall, wherein the base (110) houses a controller (112) operatively connected to the oscillation driver (114) and to the oscillation detector (116) for detecting ice formation on the sensing element (118) and outputting data indicative of icing state of the sensing element (118).

10. The apparatus as recited in any preceding claim, wherein the strut (102) is of aluminum.

11. The apparatus as recited in any preceding claim, wherein the PMG element (122) is of rare earth magnetic material.

12. A method of making an ice detection sensor apparatus (100) comprising:
additively manufacturing a strut of a base material (126) with an integrated permanent magnet, PMG, element (122), wherein the base material (126) and PMG element (122) are formed together layer by layer;
assembling a magneto strictive oscillator sensing element (118), an oscillation driver (114) operatively connected to the sensing element (118) to drive oscillation of the sensing element (118), and an oscillation detector (116) operatively connected to detect oscillation of the sensing element (118) for ice detection in an interior space (106) of the strut with a portion of the sensing element (118) extending through the strut to a space exterior of the strut.

13. The method as recited in claim 12, wherein in forming the base material (126) and PMG element layer by layer, at least some layers include both PMG material and the base material (126) together.

14. The method as recited in claim 12 or 13, wherein the base material (126) is a non-ferromagnetic metal.

15. The method as recited in claim 12, 13 or 14, wherein the base material (126) is aluminum.

## Patentansprüche

1. Eisdetektionssensorvorrichtung (100), umfassend:
eine Strebe (102), die sich entlang einer Längsachse (A) erstreckt, die Strebe (102) beinhaltend eine sich axial erstreckende Wand (104), die sich um die Längsachse (A) erstreckt, um einen Innenraum (106) zu umgeben, und eine axial gerichtete Endwand (108), die mit einem axialen Ende der sich axial erstreckenden Wand (104) verbunden ist, wobei die axial gerichtete Endwand (108) den Innenraum (106) teilweise begrenzt;
ein magnetostriktives Oszillatorsensorelement (118), das sich aus dem Innenraum (106) durch die axial gerichtete Endwand (108) erstreckt, wobei das Sensorelement (118) mit der axial gerichteten Endwand (108) zur Oszillation entlang der Längsachse (A) relativ zu der axial gerichteten Endwand (108) in Eingriff steht;
einen innerhalb des Innenraums (106) angeordneten Oszillationstreiber (114), der mit dem Sensorelement (118) wirkverbunden ist, um eine Oszillation des Sensorelements (118) anzutreiben; und
einen innerhalb des Innenraums (106) angeordneten Oszillationsdetektor (116), der wirkverbunden ist, um eine Oszillation des Sensorelements (118) zur Eisdetektion zu detektieren;
**gekennzeichnet durch** ein Permanentmagnet(PMG)-Element (122), das mit der Strebe (102) monolithisch ausgeführt ist,
wobei die Strebe (102) aus einem Basismaterial (126) mit dem integrierten Permanentmagnetelement (122) additiv gefertigt ist, wobei das Basismaterial (126) und das PMG-Element (122) Schicht für Schicht gemeinsam ausgebildet sind.

2. Vorrichtung nach Anspruch 1, wobei das PMG-Element (122) einen PMG beinhaltet, der ringförmig ist, konzentrisch zu dem Sensorelement (118) ist und sich entlang eines überwiegenden Teils einer axialen Länge des Sensorelements (118) erstreckt.

3. Vorrichtung nach Anspruch 1 oder 2, wobei das PMG-Element (122) mindestens eines von Folgendem beinhaltet:
einen ersten Permanentmagneten, PMG, seitlich des Sensorelements (118) relativ zu der Längsachse (A); und
einen zweiten PMG, der konzentrisch zu dem Sensorelement (118) relativ zu der Längsachse (A) ist.

4. Vorrichtung nach Anspruch 3, wobei das PMG-Element (122) sowohl den ersten als auch den zweiten PMG beinhaltet, wobei die sich axial erstreckende Wand (104), die axial gerichtete Endwand (108), der erste PMG (122) und der zweite PMG (124) alle monolithisch miteinander ausgeführt sind.

5. Vorrichtung nach Anspruch 3 oder 4, wobei sich der erste PMG (122) über eine größere axiale Erstreckung des Sensorelements (118) erstreckt als der zweite PMG (124).

6. Vorrichtung nach Anspruch 3, 4 oder 5, wobei das PMG-Element (122) den ersten PMG (122) beinhaltet, wobei der erste PMG (122) zylindrisch ist und sich in Längsrichtung parallel zu der Längsachse (A) erstreckt.

7. Vorrichtung nach einem der Ansprüche 3 bis 6, wobei das PMG-Element (122) den zweiten PMG (124) beinhaltet, wobei der zweite PMG (124) in einer Kreisringzylinderform ausgeführt, axial ausgerichtet und konzentrisch zu dem Sensorelement (118) ist.

8. Vorrichtung nach einem der vorhergehenden Ansprüche, ferner umfassend eine Feder (120), die mit einem Ende des Sensorelements (118) im Inneren des Innenraums (106) wirkverbunden ist, wobei die Feder (120) ausgelegt ist, um das Sensorelement (118) während Oszillationen des Sensorelements (118) vorzuspannen.

9. Vorrichtung nach einem der vorhergehenden Ansprüche, ferner umfassend eine Basis (110), die mit der Strebe (102) verbunden ist und den Innenraum (106) in Zusammenwirkung mit der sich axial erstreckenden Wand (104) und mit der axial gerichteten Endwand umschließt, wobei die Basis (110) eine Steuerung (112) beherbergt, die mit dem Oszillationstreiber (114) und mit dem Oszillationsdetektor (116) zum Detektieren von Eisbildung auf dem Sensorelement (118) und zum Ausgeben von Daten, die den Vereisungszustand des Sensorelements (118) angeben, wirkverbunden ist.

10. Vorrichtung nach einem der vorhergehenden Ansprüche, wobei die Strebe (102) aus Aluminium besteht.

11. Vorrichtung nach einem der vorhergehenden Ansprüche, wobei das PMG-Element (122) aus einem Seltenerdmagnetmaterial besteht.

12. Verfahren zum Herstellen einer Eisdetektionssensorvorrichtung (100), umfassend:
additives Fertigen einer Strebe aus einem Basismaterial (126) mit einem integrierten Permanentmagnet(PMG)-Element (122), wobei das Basismaterial (126) und das PMG-Element (122) Schicht für Schicht gemeinsam ausgebildet werden;
Zusammenbauen eines magnetostriktiven Oszillatorsensorelements (118), eines Oszillationstreibers (114), der mit dem Sensorelement (118) wirkverbunden ist, um eine Oszillation des Sensorelements (118) anzutreiben, und eines Oszillationsdetektors (116), der wirkverbunden ist, um eine Oszillation des Sensorelements (118) zur Eisdetektion zu detektieren, in einem Innenraum (106) der Strebe, wobei sich ein Abschnitt des Sensorelements (118) durch die Strebe zu einem Raum außerhalb der Strebe erstreckt.

13. Verfahren nach Anspruch 12, wobei beim Schicht-für-Schicht-Ausbilden des Basismaterials (126) und des PMG-Elements mindestens einige Schichten sowohl PMG-Material als auch das Basismaterial (126) gemeinsam beinhalten.

14. Verfahren nach Anspruch 12 oder 13, wobei das Basismaterial (126) ein nicht-ferromagnetisches Metall ist.

15. Verfahren nach Anspruch 12, 13 oder 14, wobei das Basismaterial (126) Aluminium ist.

## Revendications

1. Appareil de détection de glace (100) comprenant :
une entretoise (102) s'étendant le long d'un axe longitudinal (A), l'entretoise (102) comportant une paroi s'étendant axialement (104) s'étendant autour de l'axe longitudinal (A) pour entourer un espace intérieur (106), et une paroi d'extrémité orientée axialement (108) reliée à une extrémité axiale de la paroi s'étendant axialement (104), dans lequel la paroi d'extrémité orientée axialement (108) délimite partiellement l'espace intérieur (106) ;
un élément de détection (118) à oscillateur magnétostrictif s'étendant de l'espace intérieur (106), à travers la paroi d'extrémité orientée axialement (108), dans lequel l'élément de détection (118) vient en prise avec la paroi d'extrémité orientée axialement (108) pour l'oscillation le long de l'axe longitudinal (A) par rapport à la paroi d'extrémité orientée axialement (108) ;
un dispositif d'entraînement d'oscillation (114) situé à l'intérieur de l'espace intérieur (106) relié de manière opérationnelle à l'élément de détection (118) pour entraîner l'oscillation de l'élément de détection (118) ; et
un détecteur d'oscillation (116) à l'intérieur de l'espace intérieur (106), relié de manière opérationnelle pour détecter l'oscillation de l'élément de détection (118) pour la détection de glace ;
**caractérisé par** un élément à aimant permanent, PMG, (122) formé d'un seul tenant avec l'entretoise (102),
dans lequel l'entretoise (102) est fabriquée par fabrication additive à partir d'un matériau de base (126) avec l'élément à aimant permanent intégré (122), dans lequel le matériau de base (126) et l'élément PMG (122) sont formés ensemble couche par couche.

2. Appareil selon la revendication 1, dans lequel l'élément PMG (122) comporte un PMG de forme annulaire, concentrique à l'élément de détection (118) et s'étend sur une majorité d'une longueur axiale de l'élément de détection (118).

3. Appareil selon la revendication 1 ou 2, l'élément PMG (122) comporte au moins un des éléments suivants :
un premier aimant permanent, PMG, situé latéralement par rapport à l'élément de détection (118) par rapport à l'axe longitudinal (A) ; et
un second PMG concentrique à l'élément de détection (118) par rapport à l'axe longitudinal (A).

4. Appareil selon la revendication 3, dans lequel l'élément PMG (122) comporte à la fois le premier et le second PMG, dans lequel la paroi s'étendant axialement (104), la paroi d'extrémité orientée axialement (108), le premier PMG (122) et le second PMG (124) sont tous formés d'un seul tenant les uns avec les autres.

5. Appareil selon la revendication 3 ou 4, dans lequel le premier PMG (122) s'étend sur une plus grande étendue axiale de l'élément de détection (118) que le second PMG (124).

6. Appareil selon la revendication 3, 4 ou 5, dans lequel l'élément PMG (122) comporte le premier PMG (122), dans lequel le premier PMG (122) est cylindrique et s'étend longitudinalement parallèlement à l'axe longitudinal (A).

7. Appareil selon l'une quelconque des revendications 3 à 6, dans lequel l'élément PMG (122) comporte le second PMG (124), dans lequel le second PMG (124) est de forme cylindrique annulaire aligné axialement et concentrique avec l'élément de détection (118).

8. Appareil selon une quelconque revendication précédente, comprenant en outre un ressort (120) relié de manière opérationnelle à une extrémité de l'élément de détection (118) à l'intérieur de l'espace intérieur (106), dans lequel le ressort (120) est configuré pour polariser l'élément de détection (118) pendant les oscillations de l'élément de détection (118).

9. Appareil selon une quelconque revendication précédente, comprenant en outre une base (110) reliée à l'entretoise (102) et enfermant l'espace intérieur (106) en coopération avec la paroi s'étendant axialement (104) et avec la paroi d'extrémité orientée axialement, dans lequel la base (110) loge un dispositif de commande (112) relié de manière opérationnelle au dispositif d'entraînement d'oscillation (114) et au détecteur d'oscillation (116) pour détecter la formation de glace sur l'élément de détection (118) et fournir des données indicatives de l'état de givrage de l'élément de détection (118).

10. Appareil selon une quelconque revendication précédente, dans lequel l'entretoise (102) est en aluminium.

11. Appareil selon une revendication précédente, dans lequel l'élément PMG (122) est un matériau magnétique de terres rares.

12. Procédé de fabrication d'un appareil de détection de glace (100) comprenant :
la fabrication additive d'une entretoise en matériau de base (126) avec un élément à aimant permanent, PMG, (122) intégré, dans lequel le matériau de base (126) et l'élément PMG (122) sont formés ensemble couche par couche ;
l'assemblage d'un élément de détection (118) à oscillateur magnétostrictif, un dispositif d'entraînement d'oscillation (114) relié de manière opérationnelle à l'élément de détection (118) pour entraîner l'oscillation de l'élément de détection (118), et un détecteur d'oscillation (116) relié de manière opérationnelle pour détecter l'oscillation de l'élément de détection (118) pour la détection de glace dans un espace intérieur (106) de l'entretoise avec une partie de l'élément de détection (118) s'étendant à travers l'entretoise jusqu'à un espace extérieur de l'entretoise.

13. Procédé selon la revendication 12, dans lequel, lors de la formation du matériau de base (126) et de l'élément PMG couche par couche, au moins certaines couches comportent à la fois le matériau PMG et le matériau de base (126).

14. Procédé selon la revendication 12 ou 13, dans lequel le matériau de base (126) est un métal non ferromagnétique.

15. Procédé selon la revendication 12, 13 ou 14, dans lequel le matériau de base (126) est l'aluminium.
